Europäisches Patentamt

European Patent Office

Office européen des brevets

(19)

(11) **EP 0 614 276 B1**

(12)

# FASCICULE DE BREVET EUROPEEN

(45) Date de publication et mention
de la délivrance du brevet:
**29.12.1997 Bulletin 1997/52**

(51) Int Cl.⁶: **H03K 3/53**, G01R 29/08,
H05K 9/00

(21) Numéro de dépôt: **94400465.4**

(22) Date de dépôt: **04.03.1994**

(54) **Simulateur de champs à prédominance magnétique, et son application aux essais d'équipements**

Simulator für ein vorwiegend magnetisches Feld und seine Anwendung zum Testen von Einrichtungen

Simulator for a predominantly magnetic field and its application for testing equipments

(84) Etats contractants désignés:
**CH DE FR GB LI**

(30) Priorité: **05.03.1993 FR 9302581**

(43) Date de publication de la demande:
**07.09.1994 Bulletin 1994/36**

(73) Titulaire: **GERAC GROUPEMENT D'ETUDE ET DE RECHERCHE APPLIQUEE A LA COMPATIBILITE F-31400 Toulouse (FR)**

(72) Inventeurs:
• **Dauchy, Eric**
**F-92402 Courbevoie Cedex (FR)**
• **Meisse, Pascal**
**F-92402 Courbevoie Cedex (FR)**

(74) Mandataire: **Benoit, Monique et al**
**THOMSON-CSF-S.C.P.I.,**
**13, Avenue du Président**
**Salvador Allende**
**94117 Arcueil Cédex (FR)**

(56) Documents cités:
EP-A- 0 454 128          WO-A-93/03387
DE-B- 2 255 700          US-A- 3 411 044
US-A- 3 504 191          US-A- 3 505 564
US-A- 3 636 374          US-A- 3 710 258

• IEEE INTERNATIONAL SYMPOSIUM ON ELECTROMAGNETIC COMPATIBILITY 1987, 25 Août 1987, ATLANTA, GEORGIA, US pages 135 - 138 C. GOLDSTEIN ET AL. 'A Small Parallel Plates System for EMP Simulation'
• CPEM'90 DIGEST, CONFERENCE SUR LES MESURES ELETROMAGNETIQUES DE PRECISION, 11 Juin 1990, OTTAWA, CANADA pages 194 - 195 S. KASHYAP ET AL. 'MEASUREMENT OF EMP TRANSIENTS USING A SMALL, PARALLEL PLATE SIMULATOR'

## Description

La présente invention concerne un simulateur de champs à prédominance magnétique, et une application de ce simulateur aux essais d'équipements.

Le domaine d'application visé plus particulièrement par la présente invention concerne les essais d'évaluation de recette ou de qualification d'équipements électriques ou électroniques destinés à être placés sur des structures conductrices présentant une grande dimension, du type aéronefs, missiles, bateaux ou véhicules terrestres. De telles structures conductrices, lorsqu'elles sont exposées à une agression électromagnétique impulsionnelle, telle que la foudre, vont générer sur leur surface des distributions de courants et de charges. Il en résulte la création de champs magnétiques et électriques plus ou moins importants selon l'endroit de la structure où l'on se place. Par exemple, une structure de type avion, soumise à une agression électromagnétique impulsionnelle, va générer notamment des champs électriques prédominants en tête et en queue de l'avion, ainsi qu'à l'extrémité des ailes, alors que le milieu de la carlingue va être le siège de champs magnétiques prédominants.

Ainsi, les équipements électroniques portés par les structures sont susceptibles d'être soumis à des champs électriques ou magnétiques intenses qui risquent de perturber leur fonctionnement ou de les endommager.

On comprend par conséquent aisément la nécessité de pouvoir recréer le plus fidèlement possible les champs prédominants générés par les structures porteuses dans un certain environnement électromagnétique, de façon à pouvoir étudier le comportement des équipements.

Nous nous intéresserons par la suite uniquement aux champs à prédominance magnétique. Les simulations notamment mathématiques ont déjà permis de connaître les caractéristiques de ces champs magnétiques : il s'agit de champs sinusoïdaux amortis dont la pseudo-fréquence et le coefficient d'amortissement dépendent complètement de la structure porteuse qui génère les champs. Le niveau crête du champ magnétique dépend quant à lui principalement de l'agression impulsionnelle extérieure à la structure.

Pour générer de tels champs, il a déjà été proposé un simulateur dont on trouvera une description complète dans les Annales de Télécommunications, 47, n° 1-2, 1992, pages 73 à 84 : "Nouvelle classe de simulateurs permettant la caractérisation de dispositifs embarqués sur des structures de grandes dimensions". Un tel simulateur est constitué d'une ligne d'excitation comprenant deux nappes filaires verticales en vis-à-vis, alimentées par un générateur haute tension, et délivrant la forme et le niveau de l'agression incidente, ainsi qu'une structure métallique représentative de la structure porteuse, que l'on introduit, du moins en partie, à l'intérieur du volume défini par les deux nappes verticales, grâce à deux ouvertures pratiquées dans ces nappes. La structure métallique, qui se présente sensiblement sous la forme d'un parallélépipède allongé, est ainsi couplée à l'onde TEM créée par la ligne d'excitation, et génère des champs prédominants.

Le simulateur précédent permet de générer de façon satisfaisante des champs proches de ceux qui existent dans la réalité. Il présente cependant un certain nombre d'inconvénients :

La structure métallique utilisée, bien que considérablement simplifiée par rapport à la structure porteuse réelle qu'elle est censée représentée, doit cependant posséder une dimension égale à celle de la structure réelle. La ligne d'excitation doit alors présenter un volume suffisant pour accueillir cette structure métallique. L'encombrement du simulateur devient donc important lorsqu'il s'agit d'essayer des équipements embarqués. Cela entraîne nécessairement une mise en oeuvre lourde et longue. De plus, le simulateur est difficilement transportable.

En outre, un tel simulateur ne permet pas de faire varier simplement et rapidement les caractéristiques des champs magnétiques que l'on simule, notamment au niveau de la fréquence et du coefficient d'amortissement, puisqu'il est alors nécessaire de changer de structure métallique.

Par ailleurs, pour générer les agressions électromagnétiques impulsionnelles qui reflètent la réalité et obtenir des niveaux de champs électriques de l'ordre de 500 kV/m, le générateur utilisé doit fournir une haute tension, typiquement supérieure ou égale à 1 MV, ce qui impose d'utiliser des composants électriques spéciaux ainsi que des étages multiplicateurs de tension représentant un investissement lourd. En cas d'essais d'évaluation de recette d'un équipement, un tel générateur ne permet pas, du fait des hautes tensions mises en jeu, une incrémentation fine de son niveau de sortie.

La présente invention a pour objectif de pallier les inconvénients précités en proposant un simulateur répondant beaucoup mieux, de par sa souplesse d'utilisation, aux besoins rencontrés notamment lors d'essais d'évaluation de recette et/ou de qualification d'équipements électriques ou électroniques destinés à être embarqués sur des structures conductrices de grande dimension, à savoir :

- un encombrement faible, même pour simuler des champs magnétiques prédominants engendrés par de très grandes structures ;
- une facilité et rapidité d'adaptation en vue de faire varier un ou plusieurs paramètres caractéristiques des champs magnétiques simulés.

La présente invention a pour objet un simulateur de champs magnétiques prédominants dont les caractéristiques sont prédéterminables, caractérisé en ce qu'il est constitué d'un circuit comportant un condensateur de valeur C, des moyens de charge du condensateur, une inductance de valeur L, une résistance de valeur R et des moyens de commutation commandant la décharge du condensateur dans l'inductance, et en ce que l'inductance est réalisée par au moins une plaque de matériau conducteur repliée en forme de U dont les extrémités sont reliées électriquement respectivement au condensateur et aux moyens de commutation en série, ladite plaque formant un volume de confinement à l'intérieur duquel est généré un champ magnétique prédominant, les dimensions en longueur et en largeur de la plaque fixant la valeur L, la valeur C et la valeur R étant choisies de manière à obtenir lesdites caractéristiques prédéterminables.

Avantageusement, le simulateur selon l'invention permet de générer non seulement des champs magnétiques de forme sinusoïdale amortie, mais aussi de champs magnétiques apériodiques.

L'invention et les avantages qu'elle procure seront mieux compris au vu de la description suivante, faite en référence aux figures annexées :

- La figure 1 illustre une première mise en oeuvre d'un simulateur selon l'invention ;
- La figure 2 est une première variante du simulateur de la figure 1 dans laquelle la résistance est placée en parallèle avec l'inductance ;
- La figure 3 est une seconde variante du simulateur de la figure 1 dans laquelle l'inductance est réalisée par deux plaques ;
- La figure 4 est une variante du simulateur de la figure 2 dans laquelle l'inductance est réalisée par deux plaques ;
- Les figures 5a et 5b sont des exemples de mesures de champs respectivement magnétique et électrique générés par le simulateur selon l'invention.

Le principe de fonctionnement du simulateur de champs magnétiques objet de l'invention repose sur la décharge d'un condensateur de valeur C dans une inductance de valeur L, la charge du condensateur étant effectuée par tous moyens connus, et la décharge étant commandée par des moyens de commutation placés en série avec le condensateur.

Un tel circuit présente en outre une résistance de valeur R constituée soit par la somme des résistances parasites du circuit, soit par une résistance ajoutée au circuit en parallèle avec le condensateur ou en série avec l'inductance.

Il est connu que la décharge d'un condensateur de valeur C dans une inductance de valeur L peut engendrer deux sortes de régimes, l'un sinusoïdal amorti, l'autre apériodique, selon la valeur de la résistance R par rapport à une valeur critique $R_c$. Cette valeur critique dépend quant à elle de la position de la résistance R dans le circuit.

Afin de créer un champ de nature magnétique, l'invention propose de réaliser l'inductance au moyen d'au moins une plaque en matériau conducteur, par exemple en cuivre, placée aux bornes du condensateur. De cette façon, la décharge du condensateur génère une circulation de courants le long de la plaque, à l'origine d'un champ magnétique.

Selon l'invention, des champs magnétiques de hauts niveaux sont obtenus grâce au fait que la plaque est repliée en forme de U, chaque extrémité de ce U étant reliée respectivement au condensateur et aux moyens de commutation. Les champs magnétiques générés sont ainsi confinés à l'intérieur du volume délimité par la ou les plaques.

La plaque ou l'ensemble de plaques a donc pour double rôle de fixer la valeur L de l'inductance, et de créer un volume de confinement à l'intérieur duquel sont générés des champs magnétiques de hauts niveaux.

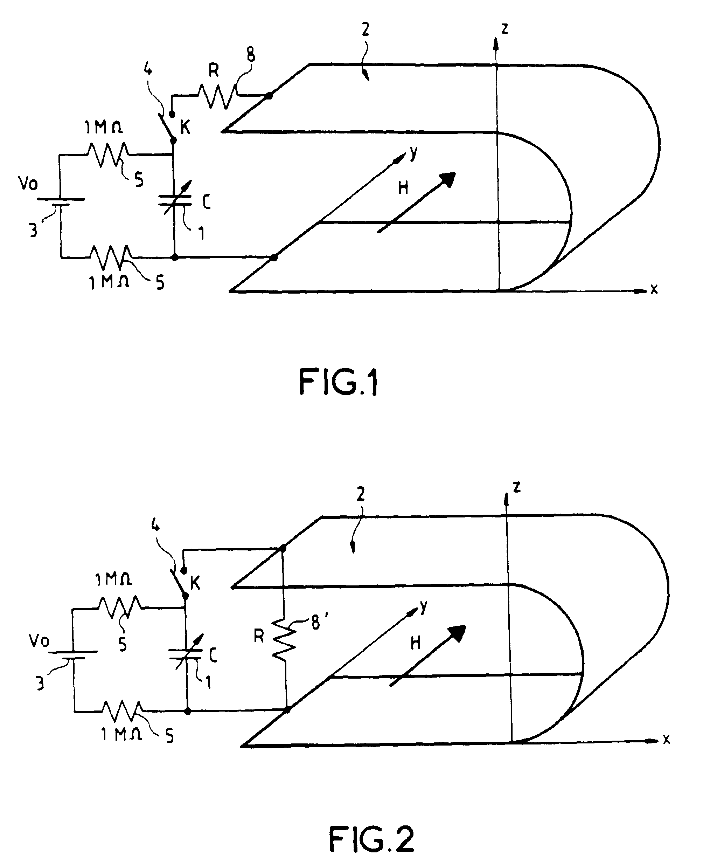

La figure 1 illustre une première mise en oeuvre d'un simulateur selon l'invention, appliquant le principe précédent :

On a représenté sur cette figure un condensateur 1 de valeur C connecté en parallèle à une plaque 2 en matériau conducteur, jouant le rôle de l'inductance de valeur L. Dans l'exemple de la figure 1, les moyens permettant la charge du condensateur comportent une alimentation 3 en tension continue $V_o$ qui vient charger le condensateur, et des résistances 5 de fortes valeurs qui déconnectent électriquement l'alimentation 3 du condensateur 1 lorsque ce dernier se décharge. Des moyens de commutation 4 placé en série entre le condensateur et l'extrémité d'une des branches du U, viennent commander la décharge du condensateur 1 dans la plaque 2. De manière préférentielle, les moyens de commutation 4 sont réalisés au moyen d'un relais au mercure commandé électriquement par un interrupteur. En effet, la fermeture d'un tel relais s'effectue pratiquement sans rebonds et ne perturbe pas le début du signal de résonance. Le simulateur comporte en outre une résistance 8 de valeur R qui est placée en série avec l'inductance. On peut montrer que, dans un tel circuit RLC, la valeur critique $R_c$ est égale à

$$2\sqrt{\frac{L}{C}}.$$

Si la résistance 8 possède une valeur R inférieure à $R_c$, le champ magnétique obtenu est de type sinusoïdal amorti dont la fréquence f et le coefficient d'amortissement Q sont donnés par les relations suivantes :

$$\left. \begin{array}{l} f = \dfrac{1}{2\,\pi\sqrt{LC}}\ \sqrt{1 - \dfrac{R^2 C}{4L}} \\[2em] Q = 2\,\pi f\,\dfrac{L}{R} \end{array} \right\} \quad (1)$$

La valeur L de l'inductance étant fixée par les dimensions de la plaque, ces dernières doivent être déterminées de façon à pouvoir couvrir une certaine gamme de fréquences avec un condensateur variable. Les dimensions doivent en outre offrir un volume de confinement suffisamment grand pour accueillir les équipements dont on désire essayer le comportement vis-à-vis d'un champ magnétique de haut niveau.

Les études de la Demanderesse ont montré par exemple que la gamme de fréquences 3 MHz - 30 MHz est entièrement couverte avec une plaque unique de 180 cm de longueur et 40 cm de largeur, et un condensateur variant de 50 pF à 5 nF. La plaque étant repliée à mi-longueur, le volume de essai disponible est alors d'environ 0,084 m³, ce qui est généralement suffisant pour accueillir les équipements à essayer.

On peut également faire varier, à fréquence quasi-constante, le coefficient d'amortissement du champ magnétique H obtenu, en changeant de résistance ou en utilisant une résistance 8 variable.

Enfin, le niveau maximal du champ magnétique H peut être ajusté par la valeur de la tension continue $V_o$.

Si l'on fixe à présent une valeur R de résistance supérieure à $R_c$, on obtient un champ magnétique apériodique dont les caractéristiques sont également ajustables.

La figure 2 illustre une première variante du simulateur de la figure 1, dans laquelle la résistance 8' de valeur R est placée en parallèle aux bornes de l'inductance 2. Cette nouvelle disposition change la valeur critique $R_c$ qui détermine le régime obtenu. On peut montrer que cette valeur est alors égale à

$$\frac{1}{2}\sqrt{\frac{L}{C}}.$$

Si la valeur R de la résistance R est supérieure à $R_c$, le régime généré par la décharge du condensateur 1 dans l'inductance 2 est une sinusoïde amortie dont les caractéristiques en fréquence f et en coefficient d'amortissement Q sont données par les relations suivantes :

$$\left.\begin{array}{l} f = \dfrac{1}{2\,\pi\,\sqrt{LC}}\ \sqrt{1 - \dfrac{L}{4R^2C}} \\ Q = 2\,\pi\,R\,C\,f \end{array}\right\} \quad (2)$$

Si, par contre, la valeur R est inférieure à $R_c$, le champ magnétique obtenu est apériodique.

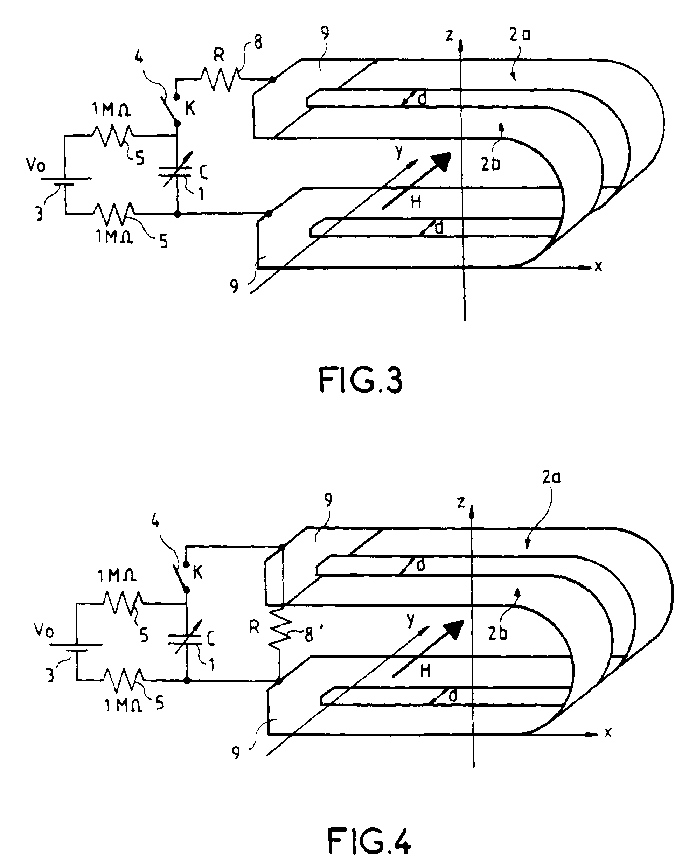

Selon une variante de réalisation du simulateur objet de l'invention, l'inductance peut être réalisée à l'aide de plusieurs plaques. Les figures 3 et 4 illustrent cette variante, respectivement dans le cas où la résistance R est en série avec l'inductance, et dans le cas où cette résistance est en parallèle avec l'inductance :

On peut voir sur ces figures que l'inductance est réalisée au moyen de deux plaques 2a, 2b, sensiblement identiques. Les deux plaques sont repliées en forme de U et sont disposées côte à côte. Elles sont reliées électriquement à leurs extrémités respectives par deux liaisons conductrices 9 auxquelles est relié symétriquement le reste du circuit. Une telle disposition permet aux courants de décharge du condensateur de mieux se répartir sur toute la surface des plaques. Il en résulte une amélioration de l'homogénéité du champ magnétique H dans tout le volume de confinement.

La distance d séparant les deux plaques 2a, 2b est ajustée de manière à minimiser les fuites à l'extérieur du volume de confinement.

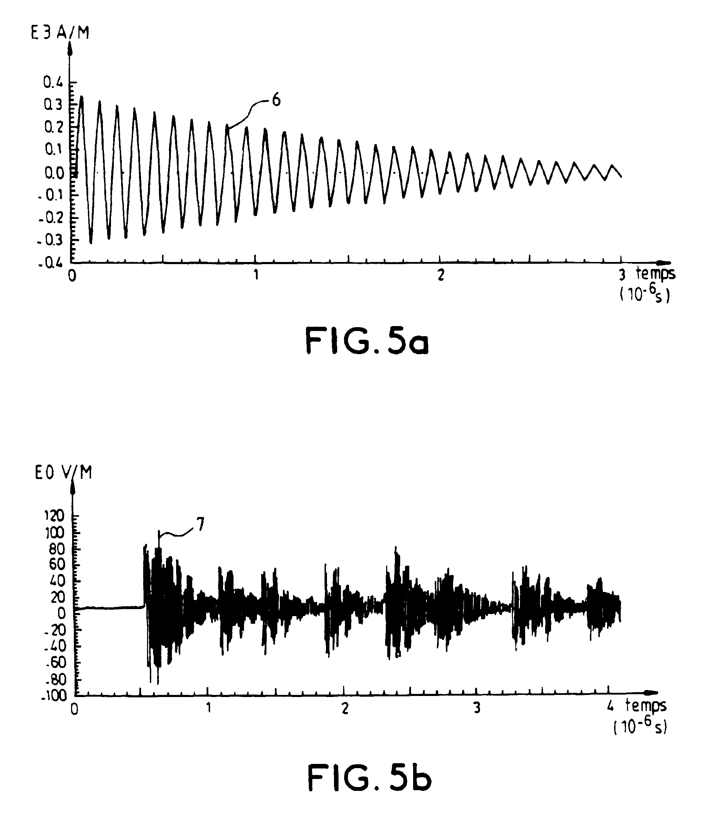

Différents essais de validation du simulateur objet de l'invention ont permis de montrer que les champs obtenus à l'intérieur du volume de confinement délimité par la ou les plaques présentent une forte prédominance magnétique. Les figures 5a et 5b illustrent, à titre d'exemple, les évolutions temporelles des champs magnétique H et électrique E mesurés à 10 MHz selon un axe y parallèle à la largeur de la plaque, dans un simulateur possédant les dimensions données précédemment à titre d'exemples et avec une tension d'alimentation de 10 kV. D'après la courbe 6 de la figure 5a, l'amplitude maximale obtenue pour le champ magnétique est d'environ 340 A/m. Sur la courbe 7 donnée à la figure 5b, l'amplitude maximale du champ électrique mesurée est de 105 V/m. Le rapport de l'impédance équivalente E/H est donc de l'ordre de 0,3Ω, traduisant une forte prédominance en champ magnétique.

Par ailleurs, d'autres essais ont permis de montrer que le champ magnétique H généré par le simulateur objet de l'invention était sensiblement homogène dans tout le volume de confinement délimité par la plaque ou l'ensemble des plaques. On peut donc disposer l'équipement à essayer a priori à n'importe quel endroit du volume.

Par rapport aux simulateurs de l'art antérieur, le simulateur objet de la présente invention présente un certain nombre d'avantages :

Il présente tout d'abord un encombrement très réduit et indépendant des champs magnétiques à générer.

Par ailleurs, il permet de simuler toutes sortes de champs magnétiques, et notamment ceux générés par une structure conductrice de grande dimension soumise à une agression électromagnétique impulsionnelle sans qu'il soit nécessaire, dans ce cas précis, de simuler l'agression. De forts niveaux de champs peuvent ici être obtenus avec une alimentation de quelques dizaines de kV, c'est-à-dire bien inférieure à celle qui serait nécessaire pour générer les agressions.

Enfin, le simulateur objet de l'invention présente le grand avantage de permettre une variation rapide et simple des différentes caractéristiques des champs magnétiques générés, à savoir :

- La fréquence des champs que l'on change simplement en changeant de condensateur ou en utilisant un condensateur variable ;
- Le niveau des champs que l'on ajuste par l'alimentation en tension $V_o$ ;
- La forme des champs, qui peut être sinusoïdale amortie ou apériodique ;
- Le coefficient d'amortissement qui peut être changé, à fréquence fixée, par l'ajustement de la valeur de la résistance.

Bien que le simulateur objet de l'invention ait été principalement développé pour servir de moyens d'essais sur des équipements embarqués sur des structures conductrices de grande dimension soumises à une agression impulsionnelle électromagnétique, il peut être également utilisé dans toute application nécessitant la création d'un champ magnétique prédominant.

**Revendications**

1. Simulateur de champs magnétiques prédominants dont les caractéristiques sont prédéterminables, caractérisé en ce qu'il est constitué d'un circuit comportant un condensateur (1) de valeur C, des moyens (3, 5) de charge du condensateur (1), une inductance (2) de valeur L, une résistance (8 ; 8') de valeur R et des moyens de commutation (4) commandant la décharge du condensateur dans l'inductance, et en ce que l'inductance (2) est réalisée par au moins une plaque de matériau conducteur repliée en forme de U dont les extrémités sont reliées électriquement respectivement au condensateur (1) et aux moyens de commutation (4) en série, ladite plaque formant un volume de confinement à l'intérieur duquel est généré un champ magnétique prédominant, les dimensions en longueur et en largeur de la plaque fixant la valeur L, la valeur C et la valeur R étant choisies de manière à obtenir lesdites caractéristiques prédéterminables.

2. Simulateur de champs magnétiques prédominants selon la revendication 1, caractérisé en ce que la résistance (8) de valeur R est placée en série entre les moyens de commutation (4) et l'inductance (2).

3. Simulateur de champs magnétiques prédominants selon la revendication 2, caractérisé en ce que la résistance (8) a une valeur R inférieure à

$$2\sqrt{\frac{L}{C}}$$

de manière à générer un champ magnétique apériodique.

4. Simulateur de champs magnétiques prédominants selon la revendication 2, caractérisé en ce que la résistance (8) a une valeur R supérieure à

$$2\sqrt{\frac{L}{C}}$$

de manière à générer un champ magnétique sinusoïdal amorti de fréquence f donnée par la relation :

$$f = \frac{1}{2\pi\sqrt{LC}}\sqrt{1 - \frac{R^2 C}{4L}}$$

5. Simulateur de champs magnétiques prédominants selon la revendication 1, caractérisé en ce que la résistance (8') de valeur R est placée en parallèle avec l'inductance (2).

6. Simulateur de champs magnétiques prédominants selon la revendication 5, caractérisé en ce que la résistance (8') a une valeur R inférieure à

$$\frac{1}{2}\sqrt{\frac{L}{C}}$$

de manière à générer un champ magnétique sinusoïdal amorti de fréquence f donnée par la relation :

$$f = \frac{1}{2\pi\sqrt{LC}}\sqrt{1 - \frac{L}{4R^2 C}}$$

7. Simulateur de champs magnétiques prédominants selon l'une quelconque des revendications précédentes, caractérisé en ce que les moyens de charge comprennent une alimentation (3) en tension continu $V_o$ chargeant le condensateur (1), et des moyens (5) pour déconnecter électriquement l'alimentation (3) lors de ladite décharge.

8. Simulateur de champs magnétiques prédominants selon l'une quelconque des revendications précédentes, caractérisé en ce que les moyens de commutation (4) sont constitués d'un relais au mercure commandé électriquement par un interrupteur.

9. Simulateur de champs magnétiques prédominants selon l'une quelconque des revendications précédentes, caractérisé en ce que le condensateur (1) et les moyens de commutation (4) sont chacun reliés à une extrémité de la plaque, au milieu de la largeur de cette plaque.

10. Simulateur de champs magnétiques prédominants selon l'une quelconque des revendications précédentes, caractérisé en ce que le condensateur est variable.

11. Simulateur de champs magnétiques prédominants selon l'une quelconque des revendications précédentes, caractérisé en ce que la résistance est variable.

12. Simulateur de champs magnétiques prédominants selon l'une quelconque des revendications précédentes, caractérisé en ce que l'inductance est réalisée au moyen d'un ensemble de plaques (2a, 2b) sensiblement identiques, repliées en forme de U et placées côte à côte, les extrémités des différentes plaques parallèles à un même plan étant reliées électriquement par des liaisons conductrices (9).

13. Application du simulateur de champs magnétiques prédominants défini dans les revendications 1 à 12 aux essais d'équipement électrique ou électronique, caractérisée en ce que ledit équipement est placé à l'intérieur du volume de confinement délimité par la plaque (2) ou l'ensemble de plaques (2a, 2b).

14. Application du simulateur selon la revendication 14, caractérisée en ce que l'équipement repose sur l'une des branches du U.

**Patentansprüche**

1. Simulator für vorherrschende Magnetfelder, deren Eigenschaften vorherbestimmbar sind, dadurch gekennzeichnet, daß er aus einer Schaltung besteht, die einen Kondensator (1) mit dem Wert C, Mittel (3, 5) zum Laden des Kondensators (1), eine Induktivität (2) mit dem Wert L, einen Widerstand (8, 8') mit dem Wert R sowie Umschaltmittel (4) aufweist, die die Entladung des Kondensators in die Induktivität steuern, und daß die Induktivität (2) durch wenigstens eine U-förmig umgebogene Platte aus einem leitfähigen Material gebildet ist, deren Enden elektrisch mit dem Kondensator (1) bzw. den Umschaltmitteln (4) in Reihe verbunden sind, wobei die Platte ein Begrenzungsvolumen bildet, in dessen Innerem ein vorherrschendes Magnetfeld erzeugt wird, wobei die Längen- und Breitenabmessungen der Platte, die den Wert L, den Wert C und den Wert R festlegen, derart gewählt sind, daß die vorherbestimmbaren Eigenschaften erhalten werden.

2. Simulator für vorherrschende Magnetfelder nach Anspruch 1, dadurch gekennzeichnet, daß der Widerstand (8) mit dem Wert R in Reihe zwischen den Umschaltmitteln (4) und der Induktivität (2) angeordnet ist.

3. Simulator für vorherrschende Magnetfelder nach Anspruch 2, dadurch gekennzeichnet, daß der Widerstand (8) einen Wert R unter

$$2 \sqrt{\frac{L}{C}}$$

aufweist, so daß ein aperiodisches Magnetfeld erzeugt wird.

4. Simulator für vorherrschende Magnetfelder nach Anspruch 2, dadurch gekennzeichnet, daß der Widerstand (8) einen Wert R über

$$2 \sqrt{\frac{L}{C}}$$

aufweist, so daß ein gedämpftes sinusförmiges Magnetfeld mit der Frequenz f erzeugt wird, die durch die folgende Beziehung gegeben ist:

$$f = \frac{1}{2\pi\sqrt{LC}} \sqrt{1 - \frac{R^2 C}{4L}}$$

5. Simulator für vorherrschende Magnetfelder nach Anspruch 1, dadurch gekennzeichnet, daß der Widerstand (8') mit dem Wert R parallel zu der Induktivität (2) angeordnet ist.

6. Simulator für vorherrschende Magnetfelder nach Anspruch 5, dadurch gekennzeichnet, daß der Widerstand (8') einen Wert R unter

$$\frac{1}{2} \sqrt{\frac{L}{C}}$$

aufweist, so daß ein gedämpftes sinusförmiges Magnetfeld mit der Frequenz f erzeugt wird, die durch die folgende Beziehung gegeben ist:

$$f = \frac{1}{2\pi\sqrt{LC}} \sqrt{1 - \frac{L}{4R^2 C}}$$

7. Simulator für vorherrschende Magnetfelder nach einem der vorhergehenden Ansprüche, dadurch gekennzeichnet, daß die Lademittel eine Versorgung (3) mit einer Gleichspannung $V_0$ aufweisen, die den Kondensator (1) lädt, sowie Mittel (5) zum elektrischen Abtrennen der Versorgung (3) bei der Entladung.

8. Simulator für vorherrschende Magnetfelder nach einem der vorhergehenden Ansprüche, dadurch gekennzeichnet, daß die Umschaltmittel (4) aus einem Quecksilberrelais bestehen, das elektrisch von einem Schalter gesteuert wird.

9. Simulator für vorherrschende Magnetfelder nach einem der vorhergehenden Ansprüche, dadurch gekennzeichnet, daß der Kondensator (1) und die Umschaltmittel (4) jeweils in der Mitte der Breite der Platte mit einem Ende der Platte verbunden sind.

10. Simulator für vorherrschende Magnetfelder nach einem der vorhergehenden Ansprüche, dadurch gekennzeichnet, daß der Kondensator variabel ist.

11. Simulator für vorherrschende Magnetfelder nach einem der vorhergehenden Ansprüche, dadurch gekennzeichnet, daß der Widerstand variabel ist.

12. Simulator für vorherrschende Magnetfelder nach einem der vorhergehenden Ansprüche, dadurch gekennzeichnet, daß die Induktivität mittels einer Einheit aus im wesentlichen identischen Platten (2a, 2b) gebildet ist, die U-förmig umgebogen und nebeneinander angeordnet sind, wobei die Enden der verschiedenen Platten, die zu einer gleichen Ebene parallel sind, durch leitfähige Verbindungen (9) elektrisch verbunden sind.

13. Anwendung des Simulators für vorherrschende Magnetfelder nach der Definition der Ansprüche 1 bis 12 auf Versuche an einer elektrischen oder elektronischen Anordnung, dadurch gekennzeichnet, daß die Anordnung im Inneren des Begrenzungsvolumens angeordnet ist, das durch die Platte (2) oder die Einheit aus Platten (2a, 2b) abgegrenzt ist.

14. Anwendung des Simulators nach Anspruch 14, dadurch gekennzeichnet, daß die Anordnung auf einem der Schenkel des U liegt.

## Claims

1. Simulator of predominant magnetic fields whose characteristics are predeterminable, characterized in that it consists of a circuit which includes a capacitor (1) of value C, means (3, 5) for charging the capacitor (1), an inductor (2) of value L, a resistor (8; 8') of value R and switch means (4) controlling the discharging of the capacitor into the inductor, and in that the inductor (2) is made from at least one plate of conducting material bent into a U-shape, the ends of which are linked electrically respectively to the capacitor (1) and to the switch means (4) in series, the said plate forming a confinement volume inside which a predominant magnetic field is generated, the length and width dimensions of the plate fixing the value L, the value C and the value R being chosen in such a way as to obtain the said predeterminable characteristics.

2. Simulator of predominant magnetic fields according to Claim 1, characterized in that the resistor (A) of value R is placed in series between the switch means (4) and the inductor (2).

3. Simulator of predominant magnetic fields according to Claim 2, characterized in that the resistor (8) has a value R of less than

$$2\sqrt{\frac{L}{C}}$$

so as to generate an aperiodic magnetic field.

4. Simulator of predominant magnetic fields according to Claim 2, characterized in that the resistor (8) has a value R of greater than

$$2\sqrt{\frac{L}{C}}$$

so as to generate a damped sinusoidal magnetic field of frequency f given by the relation:

$$f = \frac{1}{2\pi\sqrt{LC}}\sqrt{1 - \frac{R^2 C}{4L}}$$

5. Simulator of predominant magnetic fields according to Claim 1, characterized in that the resistor (8') of value R is placed in parallel with the inductor (2).

6. Simulator of predominant magnetic fields according to Claim 5, characterized in that the resistor (8') has a value R of less than

$$\frac{1}{2}\sqrt{\frac{L}{C}}$$

so as to generate a damped sinusoidal magnetic field of frequency f given by the relation:

$$f = \frac{1}{2\pi\sqrt{LC}}\sqrt{1 - \frac{L}{4R^2 C}}$$

7. Simulator of predominant magnetic fields according to any one of the preceding claims, characterized in that the charging means comprise a supply (3) of DC voltage $V_0$ charging the capacitor (1), and means (5) for electrically disconnecting the supply (3) during the said discharging.

8. Simulator of predominant magnetic fields according to any one of the preceding claims, characterized in that the switch means (4) consist of a mercury relay controlled electrically by a breaker.

9. Simulator of predominant magnetic fields according to any one of the preceding claims, characterized in that the capacitor (1) and the switch means (4) are each linked to an end of the plate, in the middle of the width of this plate.

10. Simulator of predominant magnetic fields according to any one of the preceding claims, characterized in that the capacitor is adjustable.

11. Simulator of predominant magnetic fields according to any one of the preceding claims, characterized in that the resistor is adjustable.

12. Simulator of predominant magnetic fields according to any one of the preceding claims, characterized in that the inductor is made by means of a set of substantially identical plates (2a, 2b) bent into a U-shape and placed side by side, the ends of the various plates parallel to the same plane being linked electrically by conducting links (9).

13. Application of the simulator of predominant magnetic fields defined in Claims 1 to 12 to electrical or electronic equipment testing, characterized in that the said equipment is placed inside the confinement volume delimited by the plate (2) or the set of plates (2a, 2b).

14. Application of the simulator according to Claim 14, characterized in that the equipment sits on one of the branches of the U.

FIG.1

FIG.2

FIG.3

FIG.4

FIG.5a

FIG.5b